# EUROPEAN PATENT SPECIFICATION

(11) **EP 3 257 973 B1**
(45) Date of publication and mention of the grant of the patent: **18.08.2021**
(21) Application number: 16748883.2
(22) Date of filing: 01.02.2016
(51) Int. Cl.: C25F 3/06, C21D 8/12, G03F 7/023, G03F 7/027, G03F 7/031, G03F 7/033, G03F 7/038, G03F 7/039, G03F 7/40, H01F 1/16, C22C 38/00, C22C 38/06

(54) **MANUFACTURING METHOD FOR GRAIN ORIENTED ELECTRICAL STEEL SHEET**
HERSTELLUNGSVERFAHREN FÜR KORNORIENTIERTES ELEKTROSTAHLBLECH.
PROCÉDÉ DE FABRICATION DE TÔLES D'ACIER ÉLECTROMAGNÉTIQUE À GRAINS ORIENTÉS

(30) Priority: 10.02.2015 JP 2015024501
(43) Date of publication of application: 20.12.2017
(73) Proprietor: JFE Steel Corporation, Tokyo 100-0011 (JP)
(72) Inventor: SUEHIRO, Ryuichi, Tokyo 100-0011 (JP); TERASHIMA, Takashi, Tokyo 100-0011 (JP)
(74) Representative: Hoffmann Eitle
(86) International application number: PCT/JP2016/000505
(87) International publication number: WO 2016/129235

(56) References cited:
- EP-A1- 0 469 710
- EP-A1- 2 573 193
- WO-A1-2011/162086
- WO-A1-2016/092858
- WO-A1-2016/103668
- JP-A- S6 342 332
- JP-A- S62 179 105
- JP-A- 2005 123 651
- JP-A- 2014 171 998
- JP-A- 2017 025 377

## Description

### TECHNICAL FIELD

This disclosure relates to a manufacturing method for a grain-oriented electrical steel sheet in which magnetic domain refining treatment is performed, and particularly relates to a manufacturing method for a grain-oriented electrical steel sheet in which magnetic domain refining treatment that is resistant to stress relief annealing is efficiently performed and with which excellent post-treatment iron loss is achieved.

### BACKGROUND

Grain-oriented electrical steel sheets are soft magnetic materials that are widely used as iron cores in transformers and the like. A grain-oriented electrical steel sheet is required to have low iron loss to minimize energy loss during use as an iron core.

One method for reducing the iron loss of a steel sheet exploits a phenomenon referred to as secondary recrystallization to cause the orientations of crystals in the steel sheet to be highly in accord with the Goss orientation ({110}<001> orientation) and raise the magnetic permeability, which reduces hysteresis loss. Numerous studies have been conducted in relation to methods for increasing the degree of preferred crystal orientation, and products in which deviation of crystal grain orientation from the Goss orientation is reduced to only a few degrees are being industrially manufactured.

Besides the above method, a method in which eddy current loss is reduced by refining magnetic domains in crystals is also known. For example, Patent Literature (PTL) 1 discloses a method for reducing iron loss in which a laser is irradiated linearly in a sheet transverse direction of a steel sheet surface to induce stress near the steel sheet surface and refine magnetic domains. However, one problem with this method is that it cannot be adopted in the case of a wound iron core for which stress relief annealing is necessary because the stress induced using the laser is lost when the stress relief annealing is performed, leading to increased iron loss.

In a known method for solving this problem, magnetic domain refining that does not suffer from deterioration of iron loss due to stress relief annealing (heat-resistant magnetic domain refining) is achieved by forming grooves near the surface of a steel sheet. For example, PTL 2 discloses a method in which linear grooves are formed at the surface of a steel sheet using the tip of a knife, a laser, electrical discharge machining, an electron beam, or the like. However, these methods suffer from a problem of burring at the periphery of the grooves, which necessitates a burr removal step.

PTL 3 discloses a method that does not cause burring such as described above. The method in PTL 3 utilizes photolithography in which a negative/positive rubber-based organic photosensitive liquid is applied onto a steel sheet surface, ultraviolet irradiation is then performed through a mask, portions exposed to the ultraviolet light are removed through immersion of the steel sheet in a developer, and then the steel substrate is chemically etched at the photoexposed portions through immersion in an acid such as nitric acid or hydrochloric acid.

However, due to limitations on the rate of chemical etching, the method described in PTL 3 suffers from a problem of requiring excessively large etching equipment to increase the line speed with an objective of raising productivity. Moreover, an increase in the concentration of Fe ions dissolved in the acid used in etching suppresses the etching rate, which is problematic as this makes it difficult to form grooves of uniform shape in a coil longitudinal direction.

To combat these problems, PTL 4 discloses a method in which a resist film is applied onto a steel sheet by printing after final cold rolling such that continuous or discontinuous linear regions that are oriented such as to intersect the rolling direction remain as non-application regions and, after baking of the applied resist film, etching treatment is performed to form continuous or discontinuous linear grooves at the steel sheet surface. PTL 4 discloses a gravure offset printing method as the method by which the resist film is printed and discloses a method involving electrolytic etching that allows simple control of the amount of etching as the method by which the etching is performed.

### CITATION LIST

### Patent Literature

PTL 1: JP S57-2252 B or US 4 293 350 A
PTL 2: JP S59-197520 A
PTL 3: JPH5-69284 B or JP 62-179105 A
PTL 4: JP H8-6140 B or JP 04088121 A
Furthermore, the documents JP63 042332 A, EP 2 573 193 A1 and applicant's own late published documents WO2016/092858 A1, WO2016/103668 A1 and JP2017-25377 A1 use controlled conditions at refining the magnetic domains of the oriented electrical steel sheets by patterning, photoexposure and electrolytic etching, before the primary recrystallization.

### SUMMARY

### (Technical Problem)

However, the method described in PTL 4 suffers from a problem that a doctor blade used to remove residual ink from a roller may be worn, leading to ink (resist) also being partially applied in non-application regions. When a high electrolytic etching current density is used in a state in which resist is also partially present in the non-application regions, dielectric breakdown of resist outside of the non-application regions occurs. If dielectric breakdown of the resist occurs, regions that are not etching targets may be unintentionally etched, resulting in poor magnetic domain refining and an inadequate effect in relation to iron loss improvement.

Accordingly, when the method described in PTL 4 is adopted, it is necessary to operate with a reduced current density in electrolytic etching, and thus it is necessary to reduce the line speed to ensure that the amount of etching required for magnetic domain refining is achieved. Therefore, there is an unresolved problem that it is difficult to achieve both good iron loss and high productivity through the method described in PTL 4.

In light of the problems set forth above, it would be helpful to provide a manufacturing method for a grain-oriented electrical steel sheet in which magnetic domain refining is performed and that, in particular, enables both good iron loss and high productivity to be achieved in heat-resistant magnetic domain refining treatment that is suitable for a steel sheet that is to be subjected to stress relief annealing or the like.

### (Solution to Problem)

We conducted diligent investigation into methods for forming a resist film on a steel sheet surface and etching methods with the aim of solving the problems set forth above. Through this investigation, we discovered that by applying a film containing a photosensitive resin as a resist film, modifying target portions of the resist film through photoexposure to pattern regions that are to become groove portions, and removing the resist in the regions that are to become the groove portions by development, and also by using an appropriate resist film and photoexposure conditions, it is possible to prevent residual resist in the groove portions. Furthermore, we found that in the case of a steel sheet that does not have residual resist in groove portions, unintended etching of non-groove portions can be inhibited even when electrolytic etching is performed with a high current density, and thus it is possible to both reduce iron loss of the steel sheet and ensure high productivity.

Our method is based on these findings.

The features of this invention are disclosed in claims 1 to 6.

### (Advantageous Effect)

The disclosed method enables high-productivity manufacturing of a grain-oriented electrical steel sheet that can maintain good iron loss without the effect of magnetic domain refining being lost upon stress relief annealing.

### BRIEF DESCRIPTION OF THE DRAWINGS

In the accompanying drawings:
FIG. 1 illustrates an example of photoexposure equipment that uses direct imaging;
FIG. 2 illustrates an example of mask use (mask positioned horizontally relative to a steel sheet) during irradiation in the disclosed method;
FIG. 3 illustrates another example of mask use (curved mask) during irradiation in the disclosed method;
FIG. 4 illustrates another example of mask use (mask positioned horizontally relative to a steel sheet and having open sections that move in accordance with movement of the steel sheet) during irradiation in the disclosed method; and
FIG. 5 illustrates an example of photoexposure equipment that uses projection.

### DETAILED DESCRIPTION

The following provides a detailed description of the disclosed method.

First, experiments that we conducted to investigate resist film application methods are described as experiments that led to conception of the disclosed method.

Grain-oriented electrical steel sheets used in the experiments were each manufactured by hot rolling a slab for grain-oriented electrical steel, subsequently performing hot band annealing as necessary, then performing cold rolling once, or twice or more with intermediate annealing in-between, to reach the final steel sheet thickness, subsequently performing decarburization annealing followed by final annealing, and then performing top coating.

During the manufacturing process described above, different methods were used to perform patterning of a resist film on one surface of the final cold rolled sheet that had been adjusted to a final steel sheet thickness of 0.23 mm. The resist film had a pattern in which exposed steel substrate portions of approximately 100 µm in width extended linearly in an orthogonal direction relative to the rolling direction at intervals of 5 mm in the rolling direction.

In one patterning method, a resist having an epoxy-based resin as a main component was printed by gravure offset printing and then dried. In another method, a resist film containing a bisazide compound as a photosensitive material in a rubber-based resin was applied uniformly onto the steel sheet surface. A mask that screened only groove portions was fixed 100 µm above the steel sheet surface and ultraviolet irradiation was performed through the mask. The steel sheet was then immersed in an alkaline developer to remove the film at only the groove portions.

The resist film used in the latter of these methods was a negative resist such as typically used in lithographic techniques employed in semiconductor manufacturing. Photoexposed portions of this type of resist film are cured to form a material that is insoluble in development.

The thickness of the resist film was set as 2 µm in each of these methods. After the patterning, the steel sheet having the resist film applied thereon was immersed in NaCl aqueous solution and electrolytic etching was performed. The electrolytic etching was performed under various sets of conditions in which the current density *p* with respect to the exposed steel substrate portions was adjusted, but the quantity of electric charge was fixed.

Herein, the current density *ρ* with respect to the exposed steel substrate portions is defined as *p = I*/*S* [A/cm²], where S [cm²] represents the surface area of exposed steel substrate portions when a surface area equal to that of an immersed portion of an electrode used in the electrolytic etching (herein, also referred to simply as the "electrode surface area") is selected at the steel sheet surface, and *I* [A] represents the supplied current. In other words, in a situation in which the surface area of the portion of the electrode that is immersed in the electrolysis solution is *R* [cm²], if a region of surface area R [cm²] is selected at a random position on the electrolyzed steel sheet, the surface area of exposed steel substrate portions in the selected region will be S [cm²].

Next, portions of the resist film that remained after the electrolytic etching were dissolved in an organic solvent to strip the remaining resist film. A contact-type surface roughness meter was then used to investigate the width and depth of grooves. The depth at the deepest part of a downwardly protruding region was taken to be the groove depth and the distance between two points at opposite edges of the groove at a position corresponding to half the groove depth was taken to be the groove width. For each sample, the groove depth and the groove width were measured at 4 locations in each of 5 grooves and the average of these 20 measurements was calculated.

Each of the samples was subjected to decarburization annealing and final annealing, and then to top coating to obtain a product sheet.

A test piece was cut from the product sheet obtained in this manner and was subjected to stress relief annealing. The iron loss W_{17/50} of the test piece was then measured by the method described in JIS C2550.

The results are shown in Table 1. Note that the basic current density is the current density defined by *I*/*R* [A/cm²], which is the supplied current *I* divided by the electrode surface area R.

### [Table 1]

**Table 1**

| Basic current density (A/cm²) | Current density ρ (A/cm²) | Groove width (µm) | | Groove depth (µm) | | Iron loss W_{17/50} (W/kg) | |
|---|---|---|---|---|---|---|---|
| | | Gravure offset printing | Negative resist | Gravure offset printing | Negative resist | Gravure offset printing | Negative resist |
| 0.01 | 0.5 | 105 | 102 | 20.1 | 20.3 | 0.706 | 0.703 |
| 0.05 | 2.5 | 132 | 105 | 15.3 | 19.5 | 0.708 | 0.706 |
| 0.08 | 4.0 | 165 | 104 | 11.7 | 19.2 | 0.713 | 0.704 |
| 0.10 | 5.0 | 212 | 106 | 9.8 | 20.2 | 0.71 5 | 0.709 |
| 0.15 | 7.5 | 257 | 103 | 8.2 | 19.6 | 0.716 | 0.706 |
| 0.20 | 10.0 | 282 | 101 | 7.0 | 20.5 | 0.723 | 0.709 |
| 0.30 | 15.0 | 312 | 104 | 6.6 | 19.2 | 0.727 | 0.705 |
| 0.40 | 20.0 | 344 | 103 | 6.1 | 20.3 | 0.735 | 0.706 |
| 0.50 | 25.0 | 368 | 107 | 5.5 | 18.7 | 0.739 | 0.705 |

Table 1 shows that the groove width increased, the groove depth decreased, and iron loss deteriorated when the current density *p* exceeded 7.5 A/cm² in the method in which a resist film was applied by gravure offset printing, whereas the groove width and groove depth did not significantly change in the method in which a negative resist was applied, exposed, and developed, even when the current density increased, and better iron loss was achieved through this method than through the method in which gravure offset printing was used.

Thus, it was discovered that by forming exposed steel substrate portions in a desired pattern at the surface of a steel sheet through application of a photosensitive resist onto the steel sheet surface and subsequent photoexposure and development thereof, and by then etching the exposed steel substrate portions through electrolytic etching with a high current density, the disclosed method constitutes a heat-resistant magnetic domain refining technique with which both high productivity and low iron loss can be achieved.

The following provides a more detailed description of the disclosed method.

A material for a grain-oriented electrical steel sheet that is used in the disclosed method is supplied as a slab through casting. No specific limitations are placed on the casting method. The composition of the slab that is used as the material is not specifically limited other than being a composition that is typically used for a grain-oriented electrical steel sheet. For example, the slab may have a composition containing 2 mass% to 5 mass% of Si, 0.002 mass% to 0.10 mass% of C, 0.01 mass% to 0.80 mass% of Mn, 0.002 mass% to 0.05 mass% of Al, and 0.003 mass% to 0.02 mass% of N, the balance being Fe and incidental impurities.

Next, the slab is heated as necessary and is hot rolled to obtain a hot rolled steel sheet (hot rolled sheet). The hot rolled steel sheet is then subjected to hot band annealing as necessary. Although the temperature of the hot band annealing is not specifically limited, a temperature in a range of, for example, 800 °C to 1200 °C is preferable for improving magnetic properties.

Cold rolling is then performed once, or twice or more with intermediate annealing, to obtain a cold rolled steel sheet (hereinafter, also referred to simply as a "steel sheet"). The above steps may be carried out by commonly known methods.

It is preferable that the steel sheet surface is degreased with an alkaline solution, such as sodium hydroxide solution, and then dried directly before application of a resist so as to improve adhesion of the resist to the cold rolled steel sheet in subsequent steps.

A resist film containing a photosensitive resin is applied onto at least one surface (i.e., one surface or both surfaces) of the cold rolled steel sheet obtained in the manner described above.

Although no specific limitations are placed on the method by which the resist is applied, a method in which a roll coater, a curtain coater, a bar coater, or the like is used is suitable from a viewpoint of enabling uniform application onto a strip-shaped steel sheet (also referred to as a "steel strip"). After application of the resist, it is preferable that heat treatment is carried out at 50 °C to 300 °C for 1 second to 300 seconds to stiffen the resist and improve adhesion.

A positive resist that exhibits increased solubility with respect to a developer at photoexposed portions thereof can be suitably used as the resist in the disclosed method. Since it is the photoexposed portions that are removed through development in the case of a positive resist, this allows the photoexposed portions to be set with a small surface area. In other words, the resist can be modified at photoexposed portions corresponding to the positions of grooves by directly scanning light that is focused to the desired groove width over the steel sheet. A positive resist such as the above can be freely patterned without the need for a complicated mechanism such as a mask and is, therefore, a suitable resist material for heat-resistant magnetic domain refining of a grain-oriented electrical steel sheet.

The main components of the positive resist are an alkali-soluble resin and a compound that generates an acid through light. No specific limitations are placed on the components of the positive resist in the disclosed method. The alkali-soluble resin may be, for example, a novolac resin, a polyamide-based resin, an acrylic resin, or a cycloolefin resin. The compound that generates an acid through light may be, for example, a quinone diazide compound or an onium salt.

A negative resist that exhibits low solubility with respect to a developer at photoexposed portions thereof can also be preferably used as the resist in the disclosed method. Since it is the photoexposed portions that remain after development in the case of a negative resist, this allows patterning to be performed without light scanning, through irradiation of light through a mask in which sections only remain at positions where the steel substrate is to be exposed in electrolytic etching.

Moreover, peeling of the resist due to vibrations or the like during transport of the steel sheet can be inhibited in the case of a negative resist because the negative resist exhibits excellent adhesion to the steel sheet. In terms of components, negative resists that contain cyclized rubber and a bisazide compound as a photosensitizer are well known. A resist containing such components requires an organic solvent in development. Known examples of resists for which an alkaline solution can be used in development include resists that contain an alkali-soluble resin such as polysiloxane or acrylic resin, and a photo-radical polymerization initiator such as a polyfunctional acrylic monomer and an α-aminoalkylphenone compound, or an oxime ester compound.

A chemically amplified resist is used in the disclosed method in terms of ease of use thereof. The chemically amplified resist is a resist that contains a photo acid generator and that utilizes a reaction catalyzed by an acid generated from the photo acid generator through photoexposure.

The chemically amplified resist may be a positive resist or a negative resist. In the case of a chemically amplified positive resist, the acid generated from the photo acid generator causes a deprotection reaction of a protecting group that protects an alkali-soluble group of the alkali-soluble resin, and thereby causes irradiated portions to become alkali-soluble. On the other hand, in the case of a chemically amplified negative resist, the acid generated from the photo acid generator causes a crosslinking reaction of the alkali-soluble group with a crosslinking agent, resulting in alkali-insolubility. Though use of an acid-catalyzed reaction as described above, the chemically amplified resist has high sensitivity to photoexposure, enables shortening of the photoexposure time, and can raise productivity.

No specific limitations are placed on the actual components of the chemically amplified resist in the disclosed method. For example, in the case of a chemically amplified positive resist, a resin may be used that is made alkali-insoluble through bonding of a ter-butoxycarbonyl or the like to an alkali-soluble resin having a phenolic hydroxy group, such as polyvinyl phenol, or a carboxyl group. On the other hand, a chemically amplified negative resist may contain an alkali-soluble resin and tetramethoxy glycoluril, or the like, that serves as a crosslinking agent. Examples of known photo acid generators that can be used include onium salts, nitrobenzyl esters, and diazomethane.

A resist such as described above is dissolved in an appropriate solvent and adjusted to an appropriate viscosity for use. Any solvent that is inert with respect to the resin and the photosensitizer may be used. For example, propylene glycol monomethyl ether acetate, isopropyl acetate, dimethyl sulfoxide, or the like may be used in the case of an alkali-soluble resin. On the other hand, an organic solvent is used in the case of a resist that is based on cyclized rubber.

The steel sheet having the resist applied thereon as described above is subjected to heat treatment to evaporate the solvent in the resist and cause the resist to adhere to the steel sheet. Although the heat treatment temperature and time are adjusted in accordance with the resist that is used, in general, a heat treatment temperature of approximately 50 °C to 150 °C and a heat treatment time of approximately 1 second to 500 seconds are preferable.

Next, the surface at which the resist is applied is photoexposed through irradiation of light. The light source that is used may vary depending on the photosensitizer in the resist. For example, a high-pressure mercury lamp or a laser diode may be used as a light source near to the g-line (436 nm) or the i-line (405 nm), which are the main photosensitive bands for positive resists and negative resists. In the case of a chemically amplified resist, a KrF excimer laser (248 nm), an ArF excimer laser (193 nm), or the like may be used. Moreover, X-rays or electron beams may be used as necessary.

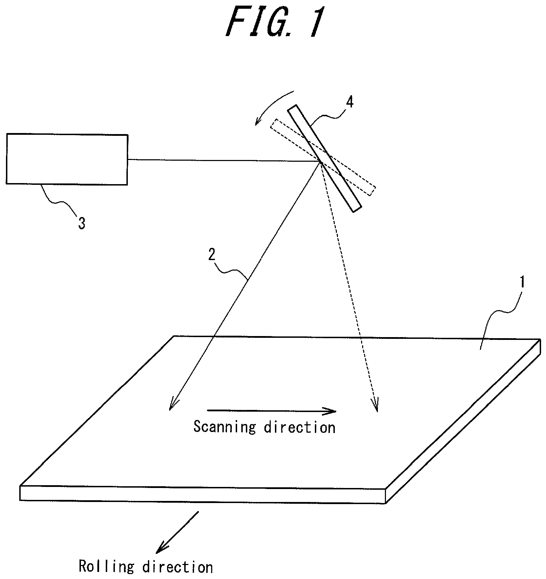

In the disclosed method, which has an objective of heat-resistant magnetic domain refining, a direct imaging method in which photoexposure is performed by scanning light over the steel sheet can be suitably used as the method of photoexposure. The direct imaging method allows photoexposure to be performed simply by synchronizing the irradiation direction of light and the movement direction of the steel sheet and does not require expensive photoexposure equipment for combination with a mask. Although the resist used in this photoexposure method is not specified, it is preferable that this method is adopted in combination with a positive resist or a chemically amplified positive resist. The reason for this is that it is only necessary to scan an appropriate spot-type light over groove formation portions having a small surface area compared to the surface area of the steel sheet surface. Accordingly, the scanning load of the optical system can be reduced and the photoexposure can be performed in a shorter period. In the case of a negative resist, light is scanned over regions other than the groove formation portions. FIG. 1 illustrates an example of photoexposure equipment that uses direct imaging. In FIG. 1, "1" indicates a steel sheet, "2" indicates light, "3" indicates an irradiating device (light source), and "4" indicates a mirror.

The light source of the light scanned over the steel sheet is preferably a laser that has high directivity and enables simple control of scanning. The laser source is preferably a solid UV laser, Ar⁺ laser, or the like with which high power can be obtained. It is preferable that the amount of photoexposure of the resist is not excessively high from a viewpoint of productivity. Specifically, the photoexposure is preferably 500 mW/cm² or less. The photoexposure is more preferably 200 mW/cm or less. The spot diameter of the laser may be equal to the desired groove width and is preferably in a range of 10 µm to 250 µm.

A proximal mask method in which a mask is positioned close to the steel sheet surface can be suitably used as the method of photoexposure in the disclosed method. In the case of a positive resist or a chemically amplified positive resist, a mask that is open at the groove portions is used. In the case of a negative resist or a chemically amplified negative resist, a mask that screens the groove portions and is open at non-groove formation regions is used. The photoexposure is performed by positioning the mask between the light source and the steel sheet such that light reaches the steel sheet through open sections of the mask.

When this screening method is adopted, it is possible to perform the photoexposure using a cheap light source with which it is difficult to obtain light with high directivity and a fine spot diameter, such as are possible with a laser.

However, if the mask and the steel sheet come into contact during the photoexposure, this may cause scratching or peeling of the resist and unintended etching of regions that are not etching targets during electrolytic etching, resulting in deterioration of iron loss. Therefore, the photoexposure in the disclosed method is performed without contact between the mask and the steel sheet.

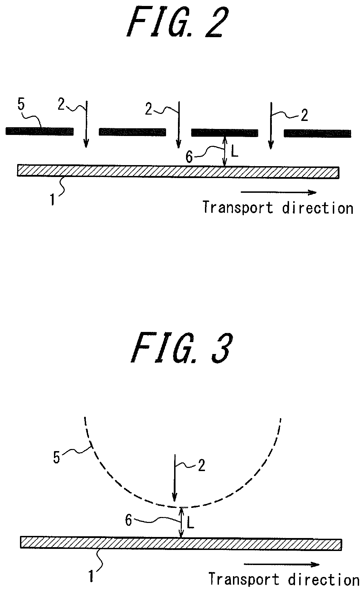

The distance between the mask and the steel sheet is preferably 50 µm or more and 5,000 µm or less. When the mask is positioned horizontally relative to the steel sheet as illustrated in FIG. 2, the distance is taken to be the distance L between the mask and the steel sheet in a vertical direction. On the other hand, when the mask is curved as illustrated in FIG. 3, the distance is taken to be the shortest distance L between the mask and the steel sheet. In FIGS. 2 and 3, "5" indicates a mask and "6" indicates the distance L between the mask and a steel sheet.

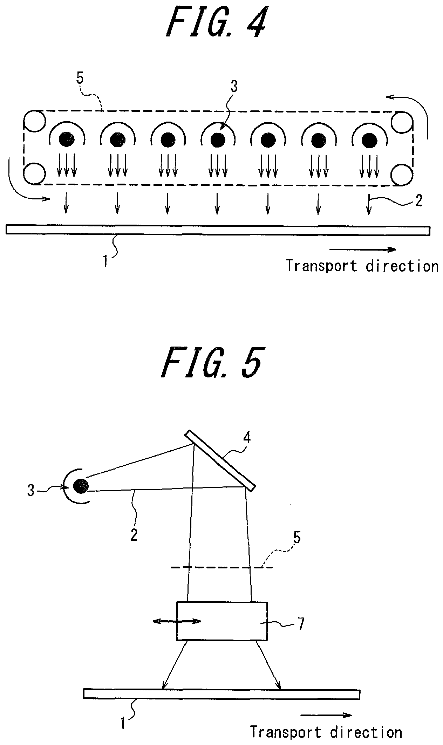

If the distance between the mask and the steel sheet is excessively large, it is not possible to form grooves of an appropriate width because light diffraction causes light to spread outside of irradiation regions. Accordingly, the distance between the mask and the steel sheet is preferably 5,000 µm or less. Conversely, if the distance between the mask and the steel sheet is excessively small, vibration of the steel sheet may cause contact between the steel sheet and the mask. Accordingly, the distance between the mask and the steel sheet is preferably 50 µm or more. A method may be adopted in which the photoexposure sections of the mask are positioned horizontally relative to the steel sheet and in which the mask and the light source are moved in accordance with movement of the steel sheet. Alternatively, in a situation in which photoexposure can be completed in a sufficiently short period, such as when a chemically amplified resist is used, a method may be adopted in which only the open sections of the mask are moved and light is periodically irradiated from a fixed-position light source as in photoexposure equipment illustrated in FIG. 4. Although the width of groove formation regions of the mask may be of roughly the same size as the width of the exposed steel substrate portions to be formed on the steel sheet, the scale thereof may be altered in accordance with the distance between the mask and the steel sheet.

A projection method in which an image obtained as light passing through a mask is projected onto the resist through an optical system including either or both of a lens and a mirror can be suitably used as the method of photoexposure in the disclosed method. The projection method can prevent damage to the mask and maintain stable photoexposure because it is not necessary for the mask to be close to the steel sheet, and thus the mask and the steel sheet do not come into contact due to vibrations associated with transport of the steel sheet or the like. The image projected onto the steel sheet may be the same size as the mask or may be scaled up or down in projection such that the image on the steel sheet is of the desired scale. In a situation in which the image is scaled down, high-precision photoexposure is possible and stable photoexposure can be maintained. On the other hand, although the precision of photoexposure in scaling up projection is poor compared to in scaling down projection, scaling up projection allows a smaller mask to be used and is beneficial in terms of cost. FIG. 5 illustrates an example of photoexposure equipment that uses projection. In FIG. 5, "7" indicates a lens.

FIGS. 4 and 5 illustrate examples of photoexposure equipment that may be used depending on the photoexposure method, but these are merely examples and are not intended as restrictions on implementation of the photoexposure method by other equipment.

Since a chemically amplified resist is used, heat treatment is performed with an appropriate temperature and time after the photoexposure. In the case of a chemically amplified positive resist, the heat treatment promotes the deprotection reaction of the protecting group for the alkali-soluble group of the alkali-soluble resin, which is catalyzed by the acid generated from the photo acid generator through the photoexposure, and thereby causes photoexposed portions to become alkali-soluble. In the case of a chemically amplified negative resist, the heat treatment causes the acid-catalyzed crosslinking reaction between the alkali-soluble resin and the crosslinking agent to occur, and thereby causes photoexposed portions to become alkali-insoluble. Although the treatment temperature and time vary depending on the resist that is used, a temperature of approximately 50 °C to 200 °C and a time of approximately 1 second to 300 seconds are preferable.

Next, groove formation portions of the resist are removed by development to expose the steel substrate and complete the patterning. A developer that is suitable for the resist is used. In the case of a resist that is based on an alkali-soluble resin, an inorganic alkali such as potassium hydroxide aqueous solution or an organic alkali such as tetramethylammonium hydroxide aqueous solution may be used. In the case of a negative resist that is based on cyclized rubber, an organic solvent such as a ketone-based solvent, an ester-based solvent, or an alcohol-based solvent may be used. Although the development step is not specified, a method involving immersion of the steel sheet in a tank filled with the developer, a method involving spraying of the developer, or the like is preferable from a viewpoint of production efficiency. The development is preferably followed by a step of washing with a rinse agent or pure water as necessary.

Thereafter, drying treatment is performed as necessary to evaporate the solvent and improve adhesion of the resist. Although the drying treatment conditions vary depending on the resist that is used and the thickness thereof, a temperature of approximately 50 °C to 300 °C and a time of approximately 1 second to 300 seconds are preferable. A standard hot-air dryer or the like can be used as the drying equipment.

The steel sheet with respect to which patterning has been completed is then electrolyzed by electrolytic etching to form grooves at the exposed steel substrate portions formed through the patterning. The electrolytic etching of the steel sheet may be performed in the same manner as in a known method with the exception of the current density with respect to the exposed steel substrate portions. The electrolysis solution used in the electrolytic etching may also be the same as used in a commonly known method. For example, NaCl aqueous solution or the like may be used.

If the current density *p = I*/*S* with respect to the exposed steel substrate portions (hereinafter, also referred to simply as the "electrolysis current density") is less than 7.5 A/cm², the etching rate per unit time is reduced, which necessitates reduction of line speed or upscaling of electrolysis equipment, and lowers productivity. Note that S [cm²] represents the surface area of the exposed steel substrate portions in a region of the steel sheet surface that is of equal surface area to the electrode surface area.

Therefore, the electrolysis current density in the disclosed method is set as 7.5 A/cm² or more. The electrolysis current density is preferably 12 A/cm² or more, and more preferably 20 A/cm² or more. Although the upper limit of the electrolysis current density is not specified, an electrolysis current density of 1,000 A/cm² or less is preferable from a viewpoint of avoiding heat generation in the steel sheet and the like.

Grooves formed through the disclosed method are controlled by controlling the groove width in patterning through photoexposure and development of the applied resist, and by controlling the groove depth through adjustment of the current density and electrolysis time in the electrolytic etching. From a viewpoint of magnetic properties, it is preferable that the groove width is 10 µm to 250 µm and that the groove direction is in a range of 30° or less from a direction orthogonal to the rolling direction. The groove depth is preferably 100 µm or less. The groove formation interval (pitch) is preferably approximately 1 mm to 30 mm.

Once the electrolytic etching is completed, a step of removing the resist from the steel sheet surface may be performed as necessary. Although the method of stripping the resist is not specified, a method may be used in which, for example, the steel sheet is immersed in an organic solvent.

After grooves have been formed in the steel sheet through the procedure described above, the steel sheet is subjected to decarburization annealing and primary recrystallization annealing. The primary recrystallization annealing may also serve as the decarburization annealing. In a situation in which the decarburization annealing is implemented in accompaniment to the primary recrystallization annealing, it is preferable from a viewpoint of achieving rapid decarburization that the annealing temperature is in a range of 800 °C to 900 °C in a wet mixed atmosphere of hydrogen and an inert gas such as nitrogen. Moreover, in a situation in which an insulating coating composed mainly of forsterite is to be formed in subsequent final annealing, annealing in the above-described atmosphere is necessary even when the C content is of a level of 0.005 mass% or less that does not necessitate decarburization.

The steel sheet subjected to the primary recrystallization annealing is then subjected to final annealing after an annealing separator composed mainly of MgO has been applied onto the surface of the steel sheet and dried thereon such that a forsterite film is formed at the steel sheet surface. The final annealing is preferably performed by holding the steel sheet at around 800 °C to 1050 °C for 20 hours or more until secondary recrystallization is developed and completed, and then raising the temperature to 1100 °C or higher. In a situation in which purification treatment is performed in consideration of iron loss properties, it is preferable that the temperature is further raised to approximately 1200 °C.

After the final annealing, the steel sheet is subjected to water washing, brushing, pickling, or the like to remove unreacted annealing separator that is adhered to the steel sheet surface, and is then subjected to flattening annealing for shape adjustment, which effectively reduces iron loss. The reason for this is that the steel sheet has a tendency to coil up due to the final annealing normally being carried out on the steel sheet in a coiled state, which causes deterioration of properties in iron loss measurement.

The surface of the steel sheet in the disclosed method may be coated with an insulating coating before, after, or during the flattening annealing. The insulating coating is preferably a tension-applying coating that reduces iron loss by applying tension to the steel sheet. For example, it is preferable to use an insulating coating formed from phosphate-chromate-colloidal silica, such has previously been described.

### EXAMPLES

### [Example 1]

A steel slab containing 3.0 mass% of Si, 0.05 mass% of C, 0.03 mass% of Mn, 0.02 mass% of Al, and 0.01 mass% of N, the balance being Fe and incidental impurities, was heated to 1400 °C and was then hot rolled to obtain a sheet thickness of 2.2 mm. The resultant steel sheet was subjected to hot band annealing at 1100 °C for 60 seconds and was then cold rolled to obtain a sheet thickness of 1.8 mm. The resultant steel sheet was subjected to intermediate annealing at 1100 °C for 60 seconds and was then cold rolled for a second time to obtain a final sheet thickness of 0.23 mm.

Cold rolled steel sheets obtained in this manner were subjected to magnetic domain refining treatment by the various methods shown in Table 2.

In the case of gravure offset printing, a mesh provided on the gravure roller was set such that non-application sections of 100 µm in width that extended in the sheet transverse direction were arranged at a pitch of 3 mm in the rolling direction, and a resist having an epoxy-based resin as a main component was printed onto the cold rolled steel sheet using this mesh.

In the case of application of a positive resist, a resist containing a novolac resin and a naphthoquinone diazide-based photosensitizer was roll coated onto the cold rolled steel sheet, a mask in which slits of 100 µm in width that extended in the sheet transverse direction were present at a pitch of 3 mm was positioned at a distance of 100 µm from the cold rolled steel sheet, and photoexposure was performed by a proximal mask method.

The photoexposure was performed for 1 second with an irradiance of 100 mW/cm² using an ultra-high pressure mercury lamp. In each resist application method, the film thickness was 2 µm. After the photoexposure, development was performed through immersion in potassium hydroxide solution for 60 seconds. Hot-air drying was then performed for 20 seconds at 120 °C.

Each steel sheet subjected to gravure printing or to photoexposure and development of an applied positive resist was then subjected to electrolytic etching or chemical etching to form grooves. The electrolytic etching was performed over 20 seconds in 30% NaCl solution at 30 °C with an electrolysis current density *p* of 20 A/cm², whereas the chemical etching was performed by immersion in FeCl₃ for 30 seconds, followed by washing with pure water.

After each of the steel sheets subjected to gravure offset printing or application of a positive resist had been etched as described above, the resist was removed therefrom by immersing the steel sheet in NaOH aqueous solution. In the case of heat-resistant magnetic domain refining treatment using a knife, a knife edge was pressed against the steel sheet surface with a fixed stress and was drawn in the sheet transverse direction such as to form grooves at a pitch of 3 mm.

The width and depth of grooves formed in each of the cold rolled steel sheets as described above were measured at 5 points in the sheet transverse direction at each of 30 positions in the coil longitudinal direction.

Thereafter, these steel sheets, along with test pieces that had not undergone magnetic domain refining treatment, were each subjected to primary recrystallization annealing that also served as decarburization annealing, and were then each subjected to application of an annealing separator composed mainly of MgO and final annealing.

With respect to each test piece obtained after final annealing in this manner, iron loss W_{17/50} at a magnetic flux density of 1.7 T and an excitation frequency of 50 Hz was measured in accordance with JIS C2550. The results of these measurements are also shown in Table 2.

### [Table 2]

**Table 2**

| Symbol | Magnetic domain refining method | Coil longitudinal direction iron loss W_{17/50} (W/kg) | | Coil longitudinal direction groove width (µm) | | Coil longitudinal direction groove depth (µM) | | Remarks |
|---|---|---|---|---|---|---|---|---|
| | | Average | Standard deviation | Average | Standard deviation | Average | Standard deviation | |
| 1 | Gravure offset printing + electrolytic etching | 0.717 | 0.037 | 121.0 | 43.5 | 21.5 | 8.8 | Comparative Example |
| 2 | Gravure offset printing + chemical etching | 0.711 | 0.021 | 105.6 | 24.2 | 32.6 | 6.7 | Comparative Example |
| 3 | Positive resist application → photoexposure/devebpment + electrolytic etching | 0.707 | 0.011 | 97.6 | 8.5 | 28.7 | 2.1 | Example |
| 4 | Positive resist application → photoexposure/development + chemical etching | 0.714 | 0.016 | 98.4 | 16.7 | 30.2 | 3.6 | Comparative Example |
| 5 | Knife | 0.712 | 0.028 | 102.1 | 35.2 | 27.5 | 8.6 | Comparative Example |
| 6 | No treatment | 0.824 | 0.032 | - | - | - | - | Comparative Example |

Table 2 shows that with the method in which grooves were formed through application of a positive resist and electrolytic etching, good iron loss was achieved and variation of groove shape and iron loss in the coil longitudinal direction was small.

### [Example 2]

Various resists shown in Table 3 were applied onto cold rolled steel sheet coils manufactured in the same manner as in Example 1. Resists other than those obtained through gravure offset printing were each applied uniformly onto the steel sheet surface using a roll coater and were subjected to projection photoexposure, via an optical system of a mirror and a lens, using a light source shown in Table 3 and a mask including either silts of 100 µm in width or screening sections of 100 µm in width. The projection magnification was actual size.

In the case of a steel sheet having a chemically amplified resist applied thereon, the steel sheet was subsequently subjected to heat treatment at 80 °C for 30 seconds. Development was then performed using a developer that was appropriate for the used resist. In the case of gravure offset printing, a gravure roll on which non-application sections of 100 µm in width were formed at a pitch of 3 mm in the rolling direction was prepared and used to print an epoxy-based resin onto the steel sheet surface.

Each of the obtained steel sheets was subjected to electrolytic etching in a 20 mass% NaCl electrolysis solution at 25°C. The electrolysis current density *p* and electrolysis time were adjusted as shown in Table 3. Thereafter, these steel sheets were each subjected to primary recrystallization annealing that also served as decarburization annealing, and were then each subjected to application of an annealing separator composed mainly of MgO and final annealing.

With respect to each test piece obtained after final annealing in this manner, iron loss W_{17/50} at a magnetic flux density of 1.7 T and an excitation frequency of 50 Hz was measured in accordance with JIS C2550. The results of these measurements are also shown in Table 3.

### [Table 3]

**Table 3**

| Resist | | Light source | Electrolysis current density p [A/cm²] | Electrolysis time [s] | Iron loss [W/kg] | | Remarks |
|---|---|---|---|---|---|---|---|
| Type | Main components | | | | Average | Standard deviation | |
| Positive resist | Novolac resin + naphthoquinone diazide-based photosensitizer | Ultra-high pressure mercury lamp | 5 | 80 | 0.715 | 0.012 | Comparative Example |
| | | | 10 | 40 | 0.705 | 0.013 | Example |
| | | | 12 | 33 | 0.703 | 0.012 | Example |
| | | | 20 | 20 | 0.702 | 0.011 | Example |
| | | | 50 | 8 | 0.706 | 0.015 | Example |
| Negative resist | Acrylic resin + pentaerythritol tetraacrylate (polyfunctional monomer) + α-aminoalkylphenone compound (radial polymerization initiator) | Ultra- high pressure mercury lamp | 5 | 80 | 0.714 | 0.013 | Comparative Example |
| | | | 10 | 40 | 0.706 | 0.015 | Example |
| | | | 12 | 33 | 0.707 | 0.013 | Example |
| | | | 20 | 20 | 0.708 | 0.014 | Example |
| | | | 50 | 8 | 0.705 | 0.011 | Example |
| Chemically amplified positive resist | Polyvinyl phenol derivative + nitrobenzyl ester (photo acid generator) | KrF excimer laser | 5 | 80 | 0.714 | 0.018 | Comparative Example |
| | | | 10 | 40 | 0.706 | 0.016 | Example |
| | | | 12 | 33 | 0.704 | 0.015 | Example |
| | | | 20 | 20 | 0.708 | 0.017 | Example |
| | | | 50 | 8 | 0.702 | 0.014 | Example |
| Chemically amplified negative resist | Polyvinyl phenol + tetramethoxy glycoluril | KrF excimer laser | 5 | 80 | 0.716 | 0.013 | Comparative Example |
| | | | 10 | 40 | 0.708 | 0.016 | Example |
| | | | 12 | 33 | 0.707 | 0.017 | Example |
| | | | 20 | 20 | 0.705 | 0.019 | Example |
| | | | 50 | 8 | 0.707 | 0.018 | Example |
| Gravure offset printing | Epoxy-based resin | - | 5 | 80 | 0.722 | 0.026 | Comparative Example |
| | | | 10 | 40 | 0.723 | 0.037 | Comparative Example |
| | | | 12 | 33 | 0.731 | 0.040 | Comparative Example |
| | | | 20 | 20 | 0.735 | 0.042 | Comparative Example |
| | | | 50 | 8 | 0.762 | 0.056 | Comparative Example |

Table 3 shows that with each method in accordance with this disclosure in which application of a positive resist, negative resist, or chemically modified resist was combined with electrolytic etching, good iron loss was achieved, without variation, through electrolysis performed with a high current density over a short period. On the other hand, in the case of the method in which gravure offset printing was combined with electrolytic etching, iron loss deteriorated as the electrolysis current density increased.

### [Example 3]

A positive resist having a novolac resin and a naphthoquinone diazide-based photosensitizer as main components was roll coated onto a cold rolled steel sheet coil manufactured in the same manner as in Example 1 with a film thickness of 3 µm and was then heat treated at 100 °C for 30 seconds. Photoexposure of one surface of the steel sheet was then performed by three photoexposure methods (proximal mask, projection, and direct imaging methods) under various conditions.

In the proximal mask method, a mask was prepared in which slits of 100 µm in width that extended in the sheet transverse direction were carved at a pitch of 5 mm in the rolling direction, and photoexposure was performed for 3 seconds using an ultra-high pressure mercury lamp with an irradiance of 50 mW/cm². The distance between the mask and the steel sheet was adjusted as shown in Table 4.

In the projection method, masks were prepared in order to enable photoexposure of regions of 100 µm in width that extended in the sheet transverse direction at a pitch of 5 mm in the rolling direction upon scaling up or scaling down projection on a steel sheet surface with a magnification shown in Table 4. An ultra-high pressure mercury lamp was used as a light source and an image passing through each of these masks was projected onto a steel sheet surface with various projection magnifications via a lens and a mirror. The photoexposure was performed for 3 seconds for the same region with the irradiance adjusted to be 50 mW/cm² at the steel sheet surface.

In the direct imaging method, a semiconductor laser having a wavelength of 375 nm was focused using an optical system including a mirror and a lens such as to have a spot diameter of 100 µm at the steel sheet surface and was scanned repeatedly in the sheet transverse direction at a pitch of 5 mm in the rolling direction. This was carried out at various laser powers. Conditions for the laser power and sheet transverse direction scanning rate are shown in Table 4.

Steel sheets obtained in this manner were each subjected to electrolytic etching in a 20% NaCl electrolysis solution at 25 °C with an electrolysis current density of 15 A/cm² and an electrolysis time of 15 seconds. Thereafter, these steel sheets were each subjected to primary recrystallization annealing that also served as decarburization annealing, and were then each subjected to application of an annealing separator composed mainly of MgO and final annealing.

With respect to each test piece obtained after final annealing in this manner, iron loss W_{17/50} at a magnetic flux density of 1.7 T and an excitation frequency of 50 Hz was measured in accordance with JIS C2550. The results of these measurements are also shown in Table 4.

### [Table 4]

**Table 4**

| | | | | | |
|---|---|---|---|---|---|
| Proximal mask method | Distance between mask and steel sheet [µm] | | Iron loss [W/kg] | | Remarks |
| | | | Average | Standard deviation | |
| | 0 | | 0.735 | 0.036 | Example |
| | 20 | | 0.731 | 0.034 | Example |
| | 40 | | 0.724 | 0.027 | Example |
| | 60 | | 0.717 | 0.017 | Example |
| | 80 | | 0.714 | 0.014 | Example |
| | 100 | | 0.708 | 0.013 | Example |
| | 500 | | 0.712 | 0.016 | Example |
| | 1000 | | 0.715 | 0.014 | Example |
| | 2000 | | 0.714 | 0.018 | Example |
| | 4000 | | 0.718 | 0.019 | Example |
| | 6000 | | 0.734 | 0.026 | Example |
| Projection method | Projection magnification | | Iron loss [W/kg] | | Remarks |
| | | | Average | Standard deviation | |
| | 0.1 | | 0.712 | 0.006 | Example |
| | 0.2 | | 0.711 | 0.007 | Example |
| | 0.5 | | 0.713 | 0.008 | Example |
| | 1 | | 0.710 | 0.011 | Example |
| | 2 | | 0.713 | 0.016 | Example |
| | 5 | | 0.715 | 0.018 | Example |
| | 10 | | 0.714 | 0.017 | Example |
| Direct imaging method | Beam conditions | | Iron loss [W/kg] | | Remarks |
| | Beam power [mW] | Scanning rate [cm/s] | Average | Standard deviation | |
| | 20 | 13 | 0.710 | 0.012 | Example |
| | 50 | 32 | 0.712 | 0.013 | Example |
| | 100 | 64 | 0.707 | 0.008 | Example |
| | 500 | 318 | 0.709 | 0.011 | Example |
| | 1000 | 637 | 0.712 | 0.010 | Example |

Table 4 shows that when the distance between the mask and the steel sheet in the conditions of photoexposure by the proximal mask method was less than 50 µm, the mask suffered severe damage due to contact with the steel sheet caused by vibrations during movement of the steel sheet and uniform photoexposure was not possible, which resulted in iron loss having a large average value and variation. Moreover, when the distance between the mask and the steel sheet exceeded 5,000 µm, light that had passed through the mask spread due to diffraction, causing unintended photoexposure of regions that were not photoexposure targets and exposure of the steel substrate thereat. This led to a wider post-etching groove width and prevented the achievement of good iron loss. In contrast, good iron loss values, without variation, were achieved when the distance between the mask and the steel sheet was in a range of 50 µm to 5,000 µm.

In photoexposure by the projection method, good iron loss values were achieved under all conditions. In particular, variation of iron loss was suppressed when scaling down projection was performed. However, it was possible to retain a good iron loss value and low variation even when scaling up projection was performed.

Furthermore, with regards to the conditions of photoexposure by the direct imaging method, it was possible to achieve a good iron loss value and low variation even when the beam power and irradiation conditions were changed.

### REFERENCE SIGNS LIST

- 1: steel sheet
- 2: light
- 3: irradiation device (light source)
- 4: mirror
- 5: mask
- 6: distance L between mask and steel sheet
- 7: lens

## Claims

1. A manufacturing method for a grain-oriented electrical steel sheet, comprising:
hot rolling a material for a grain-oriented electrical steel sheet to obtain a hot rolled steel sheet;
cold rolling the hot rolled steel sheet once, or twice or more with intermediate annealing, to obtain a cold rolled steel sheet of final sheet thickness;
forming an exposed steel substrate portion having a continuous or discontinuous linear shape in a sheet transverse direction by applying a resist film containing a photosensitive resin onto at least one surface of the cold rolled steel sheet, patterning the resist film through localized photoexposure of the surface at which the resist film is applied, and developing the resist film;
subjecting a steel sheet obtained after formation of the exposed steel substrate portion to electrolytic etching to form a groove having a continuous or discontinuous linear shape in the sheet transverse direction; and
subjecting the steel sheet resulting from the electrolytic etching to primary recrystallization annealing and subsequent final annealing, wherein
the electrolytic etching is performed at current density *p* of 7.5 A/cm² or more with respect to the exposed steel substrate portion, the current density *p* being defined as *p = I*/*S,* where *I* represents current supplied to an electrode and S represents surface area of the exposed steel substrate portion in a steel sheet surface of equal surface area to the electrode, and
the resist film is formed from a chemically amplified resist.

2. The manufacturing method for a grain-oriented electrical steel sheet according to claim 1, wherein
the resist film is formed from a positive resist and the patterning is performed through photoexposure of a groove formation region of the surface at which the resist film is applied.

3. The manufacturing method for a grain-oriented electrical steel sheet according to claim 1, wherein
the resist film is formed from a negative resist and the patterning is performed through photoexposure of a non-groove formation region of the surface at which the resist film is applied.

4. The manufacturing method for a grain-oriented electrical steel sheet according to any one of claims 1 to 3, wherein
the photoexposure of the patterning is performed by scanning light over the steel sheet and modifying the resist film through irradiation with the light.

5. The manufacturing method for a grain-oriented electrical steel sheet according to any one of claims 1 to 3, wherein
the photoexposure of the patterning is performed by irradiating the steel sheet with light that passes through an open section of a mask positioned separately to the steel sheet, and a distance between the steel sheet and the mask is 50 µm or more and 5,000 µm or less.

6. The manufacturing method for a grain-oriented electrical steel sheet according to any one of claims 1 to 3, wherein
the photoexposure of the patterning is performed by irradiating the steel sheet with light that passes through an open section of a mask spaced from the steel sheet, via either or both of a lens and a mirror.

## Patentansprüche

1. Herstellungsverfahren für ein kornorientiertes Elektrostahlblech, umfassend:
das Warmwalzen eines Materials für ein kornorientiertes Elektrostahlblech, so dass ein warmgewalztes Stahlblech erhalten wird;
das einmalige, zweimalige oder mehrmalige Kaltwalzen des warmgewalzten Stahlblechs mit Zwischenglühen, so dass ein kaltgewalztes Stahlblech mit einer Endblechdicke erhalten wird;
das Ausbilden eines freigelegten Stahlsubstratabschnitts mit einer kontinuierlichen oder diskontinuierlichen linearen Form in einer Richtung quer zum Blech durch Aufbringen eines Resistfilms, der ein lichtempfindliches Harz enthält, auf mindestens eine Oberfläche des kaltgewalzten Stahlblechs, das Strukturieren des Resistfilms durch lokale Fotobelichtung der Oberfläche, an der der Resistfilm aufgebracht ist, und das Entwickeln des Resistfilms;
das elektrolytische Ätzen des nach der Ausbildung des freigelegten Stahlsubstratabschnitts erhaltenen Stahlblechs, so dass eine Rille mit einer kontinuierlichen oder diskontinuierlichen linearen Form in einer Richtung quer zum Blech gebildet wird; und
das primäre Rekristallisationsglühen und das anschließende Endglühen des aus dem elektrolytischen Ätzen resultierenden Stahlblechs, worin
das elektrolytische Ätzen bei einer Stromdichte *ρ* von 7,5 A/cm² oder mehr in Bezug auf den freigelegten Stahlsubstratabschnitt durchgeführt wird, wobei die Stromdichte *ρ* als *ρ = I*/*S* definiert ist, wobei *I* den einer Elektrode zugeführten Strom darstellt und *S* den Oberflächenbereich des freigelegten Stahlsubstratabschnitts in einer Stahlblechoberfläche mit gleicher Oberfläche wie die Elektrode darstellt, und
der Resistfilm aus einem chemisch verstärkten Resist gebildet ist.

2. Herstellungsverfahren für ein kornorientiertes Elektrostahlblech gemäß Anspruch 1, worin
der Resistfilm aus einem Positivresist gebildet ist und die Strukturierung durch Fotobelichtung eines rillenbildenden Abschnitts der Oberfläche, an der der Resistfilm aufgebracht ist, durchgeführt wird.

3. Herstellungsverfahren für ein kornorientiertes Elektrostahlblech gemäß Anspruch 1, worin
der Resistfilm aus einem Negativresist gebildet ist und die Strukturierung durch Fotobelichtung eines nichtrillenbildenden Abschnitts der Oberfläche, an der der Resistfilm aufgebracht ist, durchgeführt wird.

4. Herstellungsverfahren für ein kornorientiertes Elektrostahlblech gemäß einem der Ansprüche 1 bis 3, worin
die Fotobelichtung der Strukturierung durch Abtasten von Licht über dem Stahlblech und durch Modifizieren des Resistfilms durch Bestrahlung mit dem Licht durchgeführt wird.

5. Herstellungsverfahren für ein kornorientiertes Elektrostahlblech gemäß einem der Ansprüche 1 bis 3, worin
die Fotobelichtung der Strukturierung durch Bestrahlung des Stahlblechs mit Licht durchgeführt wird, das durch einen offenen Abschnitt einer getrennt vom Stahlblech positionierten Maske fällt, und ein Abstand zwischen dem Stahlblech und der Maske 50 µm oder mehr und 5.000 µm oder weniger beträgt.

6. Herstellungsverfahren für ein kornorientiertes Elektrostahlblech gemäß einem der Ansprüche 1 bis 3, worin
die Fotobelichtung der Strukturierung durch Bestrahlung des Stahlblechs mit Licht durchgeführt wird, das durch einen offenen Abschnitt einer vom Stahlblech beabstandeten Maske über eine Linse oder einen Spiegel oder beides fällt.

## Revendications

1. Procédé de fabrication d'une tôle d'acier électrique à grains orientés, comprenant :
un laminage à chaud d'un matériau pour une tôle d'acier électrique à grains orientés pour obtenir une tôle d'acier laminée à chaud ;
un laminage à froid de la tôle d'acier laminée à chaud une fois ou deux fois ou plus avec un recuit intermédiaire, pour obtenir une tôle d'acier laminée à froid d'une épaisseur de tôle finale ;
une formation d'une partie de substrat d'acier exposée ayant une forme linéaire continue ou discontinue dans une direction transversale de tôle par application d'un film de réserve contenant une résine photosensible sur au moins une surface de la tôle d'acier laminée à froid, une formation de motif sur le film de réserve au moyen d'une photoexposition localisée de la surface à laquelle le film de réserve est appliqué, et un développement du film de réserve ;
une soumission d'une tôle d'acier obtenue après la formation de la partie de substrat d'acier exposée à une gravure électrolytique pour former une rainure ayant une forme linéaire continue ou discontinue dans la direction transversale de tôle ; et
une soumission de la tôle d'acier résultant de la gravure électrolytique à un recuit de recristallisation primaire et à un recuit final ultérieur, dans lequel
la gravure électrolytique est réalisée à une densité de courant p de 7,5 A/cm² ou plus par rapport à la partie de substrat d'acier exposée, la densité de courant p étant définie comme étant p = *I*/*S,* où *I* représente un courant fourni à une électrode et *S* représente une aire superficielle de la partie de substrat d'acier exposée dans une surface de tôle d'acier d'une aire superficielle égale pour l'électrode, et
le film de réserve est formé à partir d'une réserve chimiquement amplifiée.

2. Procédé de fabrication d'une tôle d'acier électrique à grains orientés selon la revendication 1, dans lequel
le film de réserve est formé à partir d'une réserve positive et la formation de motif est réalisée au moyen d'une photoexposition d'une région de formation de rainure de la surface à laquelle le film de réserve est appliqué.

3. Procédé de fabrication d'une tôle d'acier électrique à grains orientés selon la revendication 1, dans lequel
le film de réserve est formé à partir d'une réserve négative et la formation de motif est réalisée au moyen d'une photoexposition d'une région de non formation de rainure de la surface à laquelle le film de réserve est appliqué.

4. Procédé de fabrication d'une tôle d'acier électrique à grains orientés selon l'une quelconque des revendications 1 à 3, dans lequel
la photoexposition de la formation de motif est réalisée par balayage d'une lumière sur la tôle d'acier et par modification du film de réserve par irradiation avec la lumière.

5. Procédé de fabrication d'une tôle d'acier électrique à grains orientés selon l'une quelconque des revendications 1 à 3, dans lequel
la photoexposition de la formation de motif est réalisée par irradiation de la tôle d'acier avec une lumière qui passe à travers une section ouverte d'un masque positionné séparément par rapport à la tôle d'acier, et une distance entre la tôle d'acier et le masque est de 50 µm ou plus et de 5 000 µm ou moins.

6. Procédé de fabrication d'une tôle d'acier électrique à grains orientés selon l'une quelconque des revendications 1 à 3, dans lequel
la photoexposition de la formation de motif est réalisée par irradiation de la tôle d'acier avec une lumière qui passe à travers une section ouverte d'un masque espacé de la tôle d'acier par le biais soit d'une lentille, soit d'un miroir, ou des deux.
